# EUROPEAN PATENT APPLICATION

(11) **EP 2 492 951 A2**
(43) Date of publication of application: **29.08.2012**
(21) Application number: 11167409.9
(22) Date of filing: 25.05.2011
(51) Int. Cl.: H01L 21/02, H01L 21/20

(54) **Nitride based light emitting device using silicon substrate and method of manufacturing the same**

(30) Priority: 28.02.2011 KR 20110018224
(71) Applicant: Semimaterials Co., Ltd., Sengnam-si, Gyeonggi-do 463-400 (KR); Park, Kun, Bundang-gu Sengnam-si, Gyeonggi-do 463-440 (KR)
(72) Inventor: Jin, Joo, Yongin-si, 449-853, Gyeonggi-do (KR); Park, Kun, Sengnam-si Gyeonggi-do 463-440 (KR)
(74) Representative: Müller Schupfner & Partner

(57) **Abstract**

Disclosed is a nitride-based light emitting device using a silicon substrate. The nitride-based light emitting device includes a silicon (Si) substrate, a seed layer for nitride growth formed on the silicon substrate, and a light emitting structure formed on the seed layer and having a plurality of nitride layers stacked therein. The seed layer for nitride growth is comprised of GaN powders, thereby minimizing occurrence of dislocations caused by a difference in lattice constant between a nitride layer and the silicon substrate. A method of manufacturing the same is also disclosed.

## Description

### BACKGROUND

### 1. Technical Field

The present invention relates to a technique for manufacturing nitride-based light emitting devices.

### 2. Description of the Related Art

A light emitting device is a semiconductor device based on a luminescence phenomenon occurring upon recombination of electrons and holes in the device.

For example, nitride-based light emitting devices such as GaN light emitting devices are widely used. Nitride-based light emitting devices can realize a variety of colors due to high band-gap energy thereof. Further, nitride-based light emitting devices exhibit excellent thermal stability.

Nitride-based light emitting devices may be classified into a lateral type and a vertical type according to arrangement of an n-electrode and a p-electrode therein. The lateral type structure generally has a top-top arrangement of the n-electrode and the p-electrode and the vertical type structure generally has a top-bottom arrangement of the n-electrode and the p-electrode.

In the related art, a sapphire substrate is generally used as a growth substrate when manufacturing a nitride-based light emitting device.

However, the sapphire substrate has negative thermal characteristics. Thus, if the sapphire substrate is used as the growth substrate, wafer bowing, wherein the substrate bows upon nitride growth at high temperature, occurs.

Further, if the sapphire substrate is used as a growth substrate, it is difficult to manufacture a vertical type light emitting device due to insulating characteristics thereof.

On the other hand, a silicon substrate is much cheaper than the sapphire substrate and has excellent thermal and electrical characteristics. However, in manufacture of the nitride-based light emitting device, the silicon substrate is not frequently adopted as a growth substrate. This is because many dislocations are created in a growing nitride layer due to a large difference in lattice constant between the silicon substrate and the nitride layer when growing the nitride layer on the silicon substrate. Such dislocations have an adverse influence on electrical characteristics of the nitride-based light emitting device.

### BRIEF SUMMARY

One aspect of the present invention is to provide a nitride-based light emitting device that uses a silicon substrate as a growth substrate.

Another aspect of the present invention is to provide a method of manufacturing a nitride-based light emitting device, which can minimize occurrence of dislocations upon nitride growth while using a silicon substrate as a growth substrate.

In accordance with one aspect of the invention, a nitride-based light emitting device includes: a silicon substrate; a seed layer for nitride growth formed on the silicon substrate; and a light emitting structure formed on the seed layer and having a plurality of nitride layers stacked therein. Here, the seed layer is comprised of GaN powders.

The silicon substrate may be an n-type silicon substrate.

In accordance with another aspect of the invention, a method of manufacturing a nitride-based light emitting device includes: forming a seed layer for nitride growth on a silicon substrate; and sequentially growing a plurality of nitride layers on the seed layer to form a light emitting structure.

The seed layer for nitride growth may be comprised of GaN powders.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic sectional view of a nitride-based light emitting device according to an exemplary embodiment of the present invention; and
Fig. 2 is a flowchart of a method of manufacturing a nitride-based light emitting device according to an exemplary embodiment of the present invention.

### DETAILED DESCRIPTION

Exemplary embodiments of the invention will now be described in detail with reference to the accompanying drawings.

It will be understood that when an element such as a layer, film, region or substrate is referred to as being "on" another element, it can be directly on the other element or intervening elements may also be present. In contrast, when an element is referred to as being "directly on" another element, there are no intervening elements present.

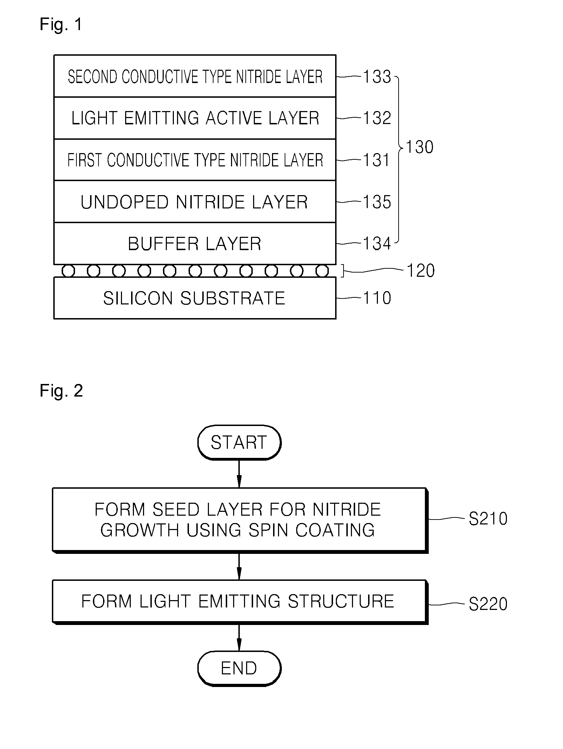

Fig. 1 is a schematic sectional view of a nitride-based light emitting device according to an exemplary embodiment of the present invention.

Referring to Fig. 1, the nitride-based light emitting device includes a silicon substrate 110, a seed layer 120 for nitride growth, and a light emitting structure 130.

The silicon substrate 110 may be a single crystal silicon substrate having a crystal direction 100, 111 or 110. Alternatively, the silicon substrate 110 may be a poly-crystal silicon substrate.

The silicon substrate has advantages of low cost, and excellent thermal and electrical characteristics as compared with sapphire substrates.

However, when growing a nitride layer on the silicon substrate, many dislocations are generated due to a large difference in lattice constant between the silicon substrate and the nitride layer. The dislocations cause reduction in luminous efficacy of a light emitting device.

Therefore, according to the present invention, the seed layer 120 for nitride growth is first grown on the silicon substrate 110 and a nitride layer is then grown thereon to minimize generation of dislocations when growing the nitride layer on the silicon substrate 110.

The seed layer 120 is formed on an upper side of the silicon substrate 110 and serves as a seed for nitride growth.

The seed layer 120 for nitride growth may be comprised of a material that allows lattice-matching with a nitride layer to be grown thereon. Since GaN is commonly used for the nitride-based light emitting device, the seed layer 120 may be advantageously comprised of GaN powders.

When growing a GaN layer using GaN powders as seeds, it is possible to minimize generation of dislocation caused by lattice mismatch during growth of the GaN layer. In addition, when growing a nitride layer on the GaN powder layer, the nitride layer is initially grown in the vertical direction and then grows in the horizontal direction, thereby enabling growth of a flat nitride layer.

The GaN powders may be attached or secured to the silicon substrate 110 by spin coating, or the like.

To allow the GaN powders to be easily attached or secured to the silicon substrate 110, the silicon substrate 110 may have an uneven surface formed with prominences and depressions. The surface unevenness may be formed as a specific or random pattern. The surface unevenness of the silicon substrate 110 may be formed by various methods such as etching or the like.

When the silicon substrate 110 has the uneven surface, the GaN powder may be easily attached or secured to the depressions on the silicon substrate 110.

The GaN powders may have an average particle size of 10 nm ~ 1 µm. The smaller the average particle size of the powders, the better the effect of suppressing generation of dislocations during nitride growth. If the average particle size of GaN powders exceeds 1 µm, the effect of suppressing generation of dislocations is insufficient, causing low luminescence efficiency of the manufactured nitride-based light emitting device. If the average particle size of GaN powders is less than 10 nm, manufacturing costs of the GaN powders are excessively increased, thereby causing an increase in manufacturing costs of the nitride-based light emitting device.

Next, the light emitting structure 130 is formed on the seed layer 120 for nitride growth.

The light emitting structure 130 is formed by stacking a plurality of nitride layers one above another.

More specifically, the light emitting structure 130 includes a first conductive type nitride layer 131, a light emitting active layer 132, and a second conductive type nitride layer 133.

The first conductive type nitride layer 131 is formed on the seed layer 120.

The first conductive type nitride layer 131 may exhibit characteristics of an n-type or p-type layer according to impurities doped therein. For example, if the first conductive type nitride layer 131 is formed by doping an n-type impurity such as silicon (Si) into a nitride layer, the first conductive type nitride layer 131 exhibits characteristics of the n-type semiconductor. On the other hand, if the first conductive type nitride layer 131 is formed by doping a p-type impurity such as magnesium (Mg) into a nitride layer, the first conductive type nitride layer 131 exhibits characteristics of the p-type layer.

The light emitting active layer 132 is formed on the first conductive type nitride layer 131. The light emitting active layer 132 may have a multiple quantum well (MQW) structure. For example, the light emitting active layer 132 may have a structure having InₓGa₁₋ₓN (0.1≤x≤0.3) and GaN alternately stacked one above another.

In the light emitting active layer 132, electrons traveling through the n-type nitride layer recombine with holes traveling through the p-type nitride layers to generate light.

The second conductive type nitride layer 133 is formed on the light emitting active layer 132 and exhibits opposite electrical characteristics to those of the first conductive type nitride layer 131.

For example, if the first conductive type nitride layer 131 is an n-type GaN layer, the second conductive type nitride layer 133 may be a p-type GaN layer. The n-type GaN layer may be formed by doping Si into a GaN layer and the p-type GaN layer may be formed by doping Mg into the GaN layer.

As such, if the first conductive type nitride layer 131 is the n-type GaN layer and the second conductive type nitride layer 133 is the p-type GaN layer, an n-type silicon substrate may be adopted as the silicon substrate 110. When the n-type silicon substrate is adopted, n-type layers may be formed as the respective layers under the light emitting active layer 132. In addition, when the n-type silicon substrate is adopted, the silicon substrate may be used as an n-electrode, thereby eliminating a process of forming the n-electrode. Accordingly, when adopting the n-type silicon substrate, it is possible to easily fabricate not only the lateral type light emitting device but also a vertical type light emitting device which has a relatively wide light emitting area to easily realize high brightness light emission.

In addition, when the n-type silicon substrate is used as the growth substrate, the silicon substrate is subjected to insignificant bowing during nitride growth at high temperature, thereby enabling uniform growth of the nitride layer.

The light emitting structure 130 may further include a buffer layer 134 on the seed layer 120. In this case, the first conductive type nitride layer 131 is formed on the buffer layer 134.

The buffer layer 134 serves to relieve stress generated during growth of the nitride layer, which is a hetero-material, on the growth substrate. The buffer layer 134 may be comprised of a nitride material such as AIN, ZrN, GaN, and the like.

If the first conductive type nitride layer 131 is an n-type nitride layer, the buffer layer 134 may also be an n-type nitride layer. Nitrides for the buffer layer 134 generally have high electric resistance. However, if the buffer layer 134 is the n-type nitride layer, the buffer layer has low electric resistance. Accordingly, it is possible to improve operational efficiency of the nitride-based light emitting device

Particularly, when the silicon substrate 110 also has n-type electrical characteristics, since electrons injected into the silicon substrate 110 can easily reach the light emitting active layer 132 without interference of a barrier, it is possible to further improve operational efficiency of the light emitting device.

Further, an undoped nitride layer 135 may be formed on the buffer layer 134 to further facilitate lattice-matching. In this case, the first conductive type nitride layer 131 is formed on the undoped nitride layer 135. The undoped nitride layer 135 may be used with an undoped substrate.

Fig. 2 is a flowchart of a method of manufacturing a nitride-based light emitting device according to an exemplary embodiment of the present invention.

Referring to Fig. 2, the method of manufacturing a nitride-based light emitting device includes operation S21 0 of forming a seed layer for nitride growth and operation S220 of forming a light emitting structure.

In operation S21 0, a seed layer for nitride growth is formed on a silicon substrate.

Here, the seed layer for nitride growth may be comprised of GaN powders.

The seed layer for nitride growth may be formed using the GaN powders in the following manner.

First, GaN powders are coated on the silicon substrate using a spin coater or the like. Then, the silicon substrate is heated to about 800~1200°C in an ammonia atmosphere in a chamber, for example a CVD chamber, such that the GaN powders are attached to the silicon substrate. In this case, the silicon substrate may be slightly etched to form an uneven surface. The surface unevenness of the silicon substrate facilitates attachment or securing of the GaN powders thereto.

Alternatively, the seed layer for nitride growth may be formed using a GaN powder-containing solution by spin-coating the solution onto the silicon substrate and drying the substrate. Here, the solution containing the GaN powders may be prepared using various solvents, such as acetone, methanol, ethylene glycol, and the like.

Either or both of the methods described above may be selectively used to form the seed layer for nitride growth. For example, the seed layer for nitride growth may be formed by spin-coating the GaN powder-containing solution onto the silicon substrate and drying the substrate, followed by heating the silicon substrate in a chamber.

Next, in the operation of forming the light emitting structure, the light emitting structure is formed by sequentially growing a plurality of nitride layers on the seed layer for nitride growth.

The light emitting structure is formed by sequentially stacking a first conductive nitride layer, a light emitting active layer, and a second conductive type nitride layer one above another. In some embodiments, a buffer layer or an undoped nitride layer may further be formed before the first conductive type nitride layer is formed.

As set forth above, the method of manufacturing a nitride-based light emitting device according to the embodiments uses the silicon substrate as a growth substrate, thereby providing various advantages of a silicon substrate.

In addition, in the method of manufacturing a nitride-based light emitting device according to the embodiments, a seed layer for nitride growth is formed using GaN powders, so that occurrence of dislocations caused by a difference in lattice constant between the silicon substrate and a nitride layer is minimized during nitride growth, thereby improving light extraction efficiency of the manufactured light emitting device.

As such, in the method of manufacturing a nitride-based light emitting device according to the embodiments, a seed layer for nitride growth is formed using GaN powders while employing a silicon substrate as a growth substrate, thereby minimizing occurrence of dislocations due to a difference in lattice constant between the silicon substrate and the nitride layer while maintaining thermal and electrical characteristics of the silicon substrate.

Further, in the method of manufacturing a nitride-based light emitting device according to the embodiments, an n-type silicon substrate may be used, thereby facilitating manufacture of a vertical type light emitting device without a process of removing the growth substrate.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A nitride-based light emitting device including a nitride-based light emitting structure formed on a substrate, **characterized by** comprising:
a silicon substrate;
a seed layer for nitride growth formed on the silicon substrate, the seed layer for nitride growth being comprised of GaN powders; and
a light emitting structure formed on the seed layer and having a plurality of nitride layers stacked therein.

2. The nitride-based light emitting device of claim 1, **characterized in that** the GaN powders have an average particle size of 10 nm to 1 µm.

3. The nitride-based light emitting device of claim 1, **characterized in that** the silicon substrate has an uneven surface.

4. The nitride-based light emitting device of claim 1, **characterized in that** the light emitting structure comprises:
a first conductive type nitride layer formed on the seed layer for nitride growth;
a light emitting active layer formed on the first conductive type nitride layer; and
a second conductive type nitride layer formed on the light emitting active layer and having opposite conductive characteristics to those of the first conductive type nitride layer.

5. The nitride-based light emitting device of claim 4, **characterized in that** the first conductive type nitride layer is comprised of an n-type GaN, and the second conductive type nitride layer is comprised of a p-type GaN.

6. The nitride-based light emitting device of claim 5, **characterized in that** the silicon substrate is an n-type silicon substrate.

7. The nitride-based light emitting device of claim 4, **characterized in that** the light emitting structure further comprises a buffer layer between the seed layer for nitride growth and the first conductive type nitride layer.

8. The nitride-based light emitting device of claim 7, **characterized in that** the buffer layer is comprised of at least one nitride selected from AIN, ZrN, and GaN.

9. The nitride-based light emitting device of claim 7, **characterized in that** the light emitting structure further comprises an undoped nitride layer between the buffer layer and the first conductive type nitride layer.

10. A method of manufacturing a nitride-based light emitting device including a nitride-based light emitting structure formed on a substrate, **characterized by** comprising:
forming a seed layer for nitride growth on a silicon substrate; and
sequentially forming a plurality of nitride layers on the seed layer to form a light emitting structure,
the seed layer for nitride growth being comprised of GaN powders.

11. The method of claim 10, **characterized in that** the forming the seed layer for nitride growth comprises placing the GaN powders on the silicon substrate, and heating the silicon substrate to attach the GaN powders to the silicon substrate.

12. The method of claim 10, **characterized in that** the forming the seed layer for nitride growth comprises coating a GaN powder-containing solution onto the silicon substrate using a spin coater, and drying the silicon substrate.
